# EUROPÄISCHE PATENTSCHRIFT

(11) **EP 1 163 532 B1**
(45) Veröffentlichungstag und Bekanntmachung des Hinweises auf die Patenterteilung: **11.05.2005**
(21) Anmeldenummer: 00988614.4
(22) Anmeldetag: 14.11.2000
(51) Int. Cl.: G01R 31/00, G01R 31/36

(54) **VERFAHREN ZUR ZUSTANDSERKENNUNG EINES ENERGIESPEICHERS**
METHOD FOR IDENTIFYING THE CONDITION OF AN ENERGY ACCUMULATOR
PROCEDE POUR LA RECONNAISSANCE D'ETAT D'UN ACCUMULATEUR D'ENERGIE

(30) Priorität: 08.12.1999 DE 19959019
(43) Veröffentlichungstag der Anmeldung: 19.12.2001
(73) Patentinhaber: ROBERT BOSCH GMBH, 70442 Stuttgart (DE)
(72) Erfinder: SARFERT, Christel, 70174 Stuttgart (DE); SCHOCH, Eberhard, 70469 Stuttgart (DE); SCHOETTLE, Richard, 75248 Oelbronn (DE)
(86) Internationale Anmeldenummer: PCT/DE2000/004023
(87) Internationale Veröffentlichungsnummer: WO 2001/042799

(56) Entgegenhaltungen:
- DE-A- 4 014 737
- US-A- 5 349 540
- US-A- 5 596 260

## Beschreibung

### Technisches Gebiet

Werden bei sicherheitskritischen Verbrauchern beispielsweise Starterbatterien als Energiespeicher eingesetzt, so sind diese Energiespeicher mit Zustandsdiagnosen zu versehen, um Auskunft darüber zu erhalten, ob der Energiespeicher aufgrund seines Zustandes noch in der Lage ist, den oder die sicherheitskritischen Verbraucher angemessen zu versorgen oder nicht.

### Stand der Technik

Bei bisherigen Lösungen einer Batteriezustandserkennung hat man versucht, mit heuristischen Methoden, wie beispielsweise der Auswertung der Ruhespannung, der Stromintegration zuverlässige Aussagen über den Ladezustand eines Energiespeichers, wie beispielsweise einer Autobatterie zu ermitteln. Mit heuristischen Verfahren läßt sich jedoch ein komplexes und nichtlineares System, wie eine Starterbatterie nur schwer erfassen; es verbleibt eine bei sicherheitskritischen Anwendungen nicht tolerierbare Restunsicherheit, Heuristischen Verfahren wohnt zwangsläufig eine Unsicherheit inne, da sich mittels dieser Methode längst nicht alle auf ein komplexes System einwirkenden Einflüsse erfassen und berücksichtigen lassen. Stromintegrationsverfahren sind dadurch mit Unsicherheiten behaftet, daß es dabei zu einer nichtkalkulierbaren Aufsummierung von Meßfehlern kommen kann, die im Ergebnis, die an einen sicherheitskritische Verbraucher versorgenden Energiespeicher zu stellenden Sicherheitskriterien nicht mehr erfüllen.

Aus EP 0 505 333 A2 ist ein modellgestütztes Verfahren zur Zustandserkennung und -prognose eines Energiespeichers bekannt geworden. Der Einsatz eines modellgestützten Zustandserkennungsverfahrens ist bisher beispielsweise bei Anwendungen an Kraftfahrzeugen deshalb unterblieben, weil das Modell zu ungenau und die bisherigen Schätzalgorithmen nicht ausreichend zuverlässig und umfassend ausgestaltet waren.

Aus der US-PS 5,596,260 ist ein Verfahren zur Erkennung des Zustandes eines Energiespeichers bekannt, bei dem Istgrößen einem modellbasierten Parameterschätzer zugeführt werden. Der modellbasierte Parameterschätzer schätzt aus den zugeführten Größen Parameter ab, die einem das Verhalten des Energiespeichers extrapolierenden Prädiktor zugeführt werden. Aus diesen zugeführten Größen wird der Zustand des Energiespeichers abgeschätzt.

Aus der US-PS 5,349,540 ist ein Verfahren zur Erkennung des Zustandes eines Energiespeichers bekannt, das aus gemessenen Größen mit Hilfe eines Modells Vorhersagewerte bestimmt, die den aktuellen Zustand des Energiespeichers erkennen lassen.

Ein weiteres Verfahren zur Erkennung des Zustandes eines Energiespeichers ist aus der DE-OS 40 14 737 bekannt. Bei diesem bekannten Verfahren werden die Prozesseingangsgrößen des Energiespeichers gemessen und in einem Rechner verarbeitet. Dabei wird nach dem Prinzip des indirekten Messens ein vorgebbares Modell eingesetzt, das eine Parameterschätzung ermöglicht. Durch Vergleich der Prozesseingangsgrößen mit nachwirkend ermittelten Größen kann eine Adaption des Modells bzw. der Schätzung durchgeführt werden.

### Darstellung der Erfindung

Mittels des erfindungsgemäß vorgeschlagenen Verfahrens ist eine kontinuierliche Erfassung und Erkennung der Istzustandsgrößen, d.h. des Ladezustandes eines Energiespeichers möglich. Die modellgestützte Batteriezustandserkennung, basierend auf einem Filter - beispielsweise einem Kalman-Filter - und einem Paramterschätzer mit Online-Paramteridentifikation mit Überwachungsebene und Prädiktor, ermöglicht eine hochgenaue und sehr zuverlässige Energiespeicherdiagnose für sicherheitskritische Verbraucher. Durch die Parameterschätzung ist es möglich, sich aufgrund der Alterung des Energiespeichers oder aufgrund von Defekten sich ändernde Modellparameter festzustellen und das Modell, auf dem die Schätzungen im wesentlichen beruhen, ständig dem Istzustand anzugleichen und nachzuführen. Die adaptierten Modellparameter werden an das Filter übertragen, welches ebenfalls auf einem Modell basierend aufgebaut ist, dessen Schätzungswerte sich dadurch ebenfalls verbessern lassen, wodurch sich insgesamt die Prognosegenauigkeit erheblich steigern läßt. Die Trennung der Schätzung von Zustandsgrößen und Parametern zum einen durch das Filter, zum anderen durch den Parameterschätzern bewirkt, daß Fehlschätzungen vermieden bzw. unwahrscheinlich werden, da die in die Schätzungsroutinen eingehenden Modellparameter und die Istzustandsgrößen des abzufragenden Energiespeichers stets aktuell sind. Fehlschätzungen treten häufig dann auf, wenn sehr viele Größen gleichzeitig vom Kalman-Filter geschätzt werden müssen, wie bei dem komplexen System Energiespeicher notwendig.

Die Parameter lassen sich im Parameterschätzer in einem anderen zeitlichen Horizont schätzen, verglichen mit den Filtergrößen, was eine Verringerung des numerischen Aufwandes und damit eine Entlastung des Prozessors bedeutet. Die Schätzung der Parameter durch den Parameterschätzer findet jedoch häufig genug statt, um einen plötzlichen Ausfall des Energiespeichers rechtzeitig zu detektieren.

Anhand einer Überwachungsebene können die vom Parameterschätzer und vom Filter geschätzten Größen auf Plausibilität überprüft werden. Mittels der Überwachungsebene läßt sich der Parameterschätzer jederzeit aktivieren. Hierarchisch betrachtet, ist die Überwachungsebene beiden Schätzroutinen, dem Parameterschätzer und dem Kalman-Filter jeweils übergeordnet. Liegen die Schätzwerte außerhalb vorab definierter Bereiche, kann die Rücksetzfunktion, beispielsweise des Filters durch die Überwachungsebene initiiert werden.

Die geschätzten Werte lassen sich einem Prädiktor zuführen, der unter Zugrundelegung, des Ist-Zustandes des Energiespeichers, bezogen auf die Belastung durch die sicherheitskritische Anwendung, dessen Zustand extrapoliert. So läßt sich der ungünstig anzunehmende Fall simulieren und abprüfen, ob bei einem im schlechten Zustand befindlichen Energiespeicher ein mögliches und ein kurz bevorstehendes Versagen des Energiespeichers zu befürchten steht.

### Zeichnung

Anhand einer Zeichnung wird die Erfindung nachstehend näher erläutert.

Es zeigt:

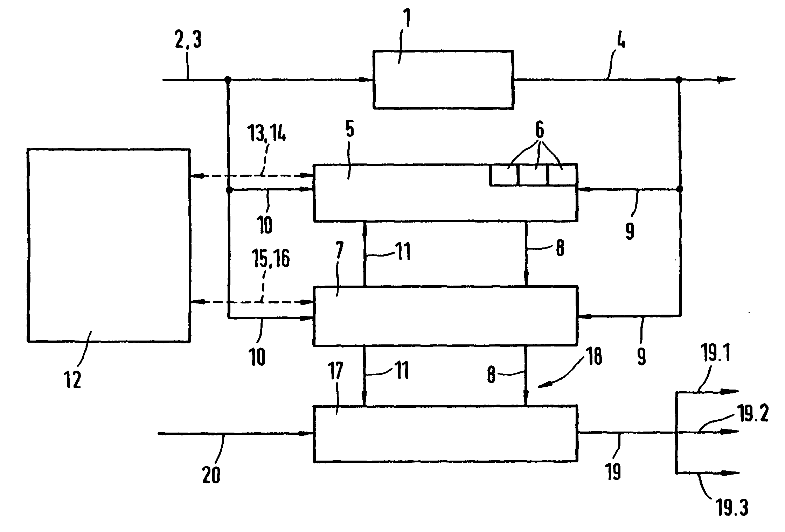

- Figur 1: Die zur Durchführung des Verfahrens zur Zustandserkennung eines Energiespeichers notwendigen Bausteine und Routinen sowie deren Verknüpfung miteinander.

In der Darstellung gemäß Figur 1 werden die Istzustandsgrößen eines Energiespeichers 1, wie beispielsweise die Spannung 4, der Strom 2 sowie die Temperatur 3, der der Energiespeicher 1 aktuell ausgesetzt ist, als Eingangsgröße 9 bzw. 10 voneinander entkoppelt, jeweils einen modellbasiertem Parameterschätzer 5 und einem modellbasiertem Modellbaustein 7 zugeführt. Beim Filter 7 kann es sich beispielsweise um ein Kalman-Filter handeln. Das Filter 7 ist in der Lage, die Zustandsgrößen mittels einer Strom- und Spannungsmessung am Energiespeicher 1 so zu schätzen, daß diese den tatsächlichen inneren Größen am Energiespeicher 1 entsprechen. Dies erlaubt eine recht genaue Aussage über dessen Ladezustand.

Am Energiespeicher 1 sich einstellende Alterungserscheinungen oder sich durch Defekte einstellende Änderungen der Modellparameter 6, die dem Schätzungsmodell, welches im Parameterschätzer 5 implementiert ist zugrundeliegen, werden vom Filter 7 berücksichtigt. Dem Filter 7 werden diese Größen entkoppelt vom Parameterschätzer zugeführt. Diese Eingangsgrößen 9 und 10, die beispielsweise die Batteriespannung, der Strom und/oder eine Temperatur sind, werden kontinuierlich erkannt und die Modellparameter 6 entsprechend adaptiert, so daß das Schätzungsmodell an den tatsächlichen Zustand des Energiespeichers 1 kontinuierlich angeglichen wird und die Abweichungen vom diesem möglichst gering gehalten werden. Dies erlaubt die zuverlässige Erkennung plötzlich auftretender Energiespeicherdefekte, wie beispielsweise Kurzschlüsse oder Plattenbrüche in dessen Zellen. Diese würden durch ein Filter 7 nicht ohne weiteres mit der geforderten Zuverlässigkeit detektiert werden, da sich solche Defekte nicht unmittelbar auf den inneren Zustand des Energiespeichers 1 auswirken. Durch eine Parameterübertragung 8 lassen sich die Modellparameter 6, die sich aufgrund der Eingangsgrößen 9, 10 im modellbasierten Parameterschätzer 5 ergeben haben, an das Filter 7 übertragen. Dadurch wird wirksam verhindert, daß aufgrund zu starken Modellrauschens die Schätzungswerte des Filters 7 ungenau werden. Durch die Änderung der Modellparameter 6 im modellbasierten Parameterschätzer 5 wird das ebenfalls modellbasierte Filter 7 den sich einstellenden Änderungen am Modell des Parameterschätzers 5 nachgeführt, seine Modellparameter entsprechend adaptiert und aktualisiert. Durch diese Systemkonfiguration lassen sich abstrakte Modelle als lernende Modelle gestalten, die ein fallspezifisches, adaptives Nachführen eines Modells an vorgefundene und sich ändernde Einflußgrößen ermöglichen.

Durch die entkoppelte Zuführung der Einflußgrößen 9, 10 an Parameterschätzer 5 und Filter 7 wird eine Überforderung des Kalman-Filters 7 vermieden, dergestalt, daß dessen Schätzgrößenwerte, Schätzungstendenz, biasfrei erfolgen können. Bias-behaftete Schätzgrößen treten immer dann auf, wenn viele Größen gleichzeitig vom Kalman-Filter 7 zu schätzen sind.

Die Entkopplung der Zuführung der Einflußgrößen 9, 10 zu Parameterschätzer 5 und zum Filter 7 erlaubt eine geringere Prozeßbeanspruchung dadurch, daß der Parameterschätzer 5 selbst in einem größeren zeitlichen Raster noch zuverlässig arbeitet. Die größeren Zeitabstände t₁, innerhalb der die Eingangsgrößen 9, 10 im Parameterschätzer 5 zuführbar sind, sind dadurch begründet, daß sich die Parameter in der Regel nicht so schnell ändern, wie die Zustandsgrößen 2, 3 oder 4 des Energiespeichers 1. Die Intervallänge t₁ findet ihre maximale Grenze jedoch darin, daß die Schätzung der Parameterwerte noch so häufig erfolgen muß, daß ein plötzlich auftretender Defekt am Energiespeicher 1 detektierbar ist. Durch die den Parameterschätzer 5 hierarchisch übergeordnete Überwachungsebene 12, läßt sich eine Schätzung der Parameter auch unabhängig vom Intervall t₁ realisieren, eine Schätzung der Parameter kann zu jeder Zeit erfolgen. Verglichen zum Schätzintervall t₁ am Parameterschätzer 5 erfolgt die Schätzung am Filter 7 in kürzeren zeitlichen Intervallen t₂.

Um eine zu starke Divergenz der durch den Parameterschätzer 5 und das Filter 7 ermittelten Schätzwert zu vermeiden, werden die Schätzwerte der beiden Bausteine 5 und 7 in einer Überwachungsebene 12, einer Plausibilitätsuntersuchung unterworfen. Dazu steht die Überwachungsebene 12 über Datentransferverbindungen 13, 15 mit dem Parameterschätzer 5 und dem Filter 7 in Verbindung. Liegt ein Schätzwert, oder liegen beide Schätzwerte in einer Größenordnung vor, die in dieser Kombination aus Plausibilitätsgründen nicht möglich sind - beispielsweise eine wesentlich zu hohe Spannung bei extrem niedrigen Außentemperaturen - so initiiert die Überwachungsebene 12 über Rücksetzkanäle 14, 16 am Parameterschalter 5 und am Filter 7 ein Rücksetzen der Schätzwerte sowie eine neue Schätzung. Daneben kann auch ein Rücksetzen der für nicht plausibel erachteten Schätzwerte auf die zuletzt ermittelten plausiblen Schätzwerte erfolgen.

Aus der in Figur 1 dargestellten Konfiguration geht hervor, daß von Parameterschätzer 5 eine Parameterübertragung 8 zur Anpassung der Modelldaten im Filter 7 erfolgt, so daß dieses dort abgelegte Modell den tatsächlichen Gegebenheiten eher entspricht; ein im Filter 7 ermittelter Zustandsvektor 11 wird an den Parameterschätzer 5 übertragen, dessen Parameterdaten 8 ihrerseits die Modellparameter im Kaman-Filter 7 beeinflussen.

Nach erfolgter Plausibilitätsuntersuchungen wird ein Prädiktor 17 durch die Größen 8 und 11 parametriert. Der Prädiktor 17 basiert auf einem im Vergleich zum im Filter 7 implementierten Modell einfacheren Modell. Der Grad der Vereinfachung des im Prädiktor 17 implementierten Modells hängt davon ab, welche Belastungsfälle des Energiespeichers 1 durch die sicherheitskritischen Verbraucher am Prädiktor 17 zu simulieren sind. Das im Prädiktor 17 implementierte Modell muß sich bei verschiedenen - ausgewählten oder vorgebbaren - Belastungsfällen am Energiespeicher 1 einstellende Zustandsgrößen ausreichend genau wiedergeben können. Anhand der durch im Rahmen einer Parametrierung 18 erfolgten Übermittlung des Zustandsvektors 11 und der Parameterübertragung 8 extrapoliert der Prädiktor 17 den momentan herrschenden Zustand des Energiespeichers 1 bezogen auf die Belastung durch den oder die sicherheitskritischen Verbraucher. Die Belastungsfälle lassen sich dem Prädiktor 17 als Eingabedaten - Stimula 20 - zuführen und dann bei ungünstigsten Bedingungen durchspielen und simulieren, wobei die Bedingungen anwenderspezifisch vorgeben werden können. Anhand des im Prädiktors 17 implementierten Modells ist eine Aussage darüber möglich, ob ein mögliches Versagen des Energiespeichers 1 bevorsteht oder nicht. Als ein Beispiel sei eine Startsimulation erwähnt. Kann am Prädiktor 17 erfolgreich im Rahmen einer Startroutine 19.3 ein Start bei einer erheblich niedrigeren Temperatur, als der gerade herrschenden Temperatur 3 simuliert werden, ist sichergestellt, daß auf absehbare Zeit ein Versagen des Energiespeichers 1 nicht zu befürchten ist. Kann im Rahmen einer Bremsroutine 19.1 am Prädiktor 17 erfolgreich vorausberechnet werden, daß die für gesetzlich vorgeschriebenen zwanzig Betriebsbremsungen beispielsweise benötigte Energie vorhanden ist, so läßt sich das Fahrzeug noch sicher bremsen, wenn nur auf den Energiespeicher 1 als Energiequelle zurückgegriffen werden kann.

Anhand der Routinen 19.1, 19.2 und 19.3 kann auch eine Hierarchie implementiert werden, nach der die einzelnen Routinen zu durchlaufen sind. Die wichtigste ist die Bremsroutine 19.1 bei bewegtem Fahrzeug; der Energiebedarf hierfür ist immer sicherzustellen; sodann ist eine Lenkroutine 19.2 zu durchlaufen, um die Sicherstellung des Energiebedarfes bei bewegtem Fahrzeug hierfür abzuschätzen und dessen Deckung durch den Energiespeicher 1 vorherzubestimmen. Die Startroutine 19.3 ist bei stillstehendem Fahrzeug von Bedeutung, um den Motor anzulassen; bei stillstehendem Fahrzeug spielen dann die Routinen 19.1 bzw. 19.2 eine eher untergeordnete Rolle, da für Brems- und Lenkvorgänge keine Energiedeckung benötigt wird.

### Bezugszeichenliste

- 1: Energiespeicher
- 2: Istgröße Strom
- 3: Istgröße Temperatur
- 4: Istgröße Spannung
- 5: Parameterschätzer
- 6: Modellparameter
- 7: Filter
- 8: Parameterübertragung
- 9: Eingangsgröße Spannung
- 10: Eingangsgrößenstromtemperatur
- 11: Zustandsvektor
- 12: Überwachungsebene
- 13: Datenaustausch Parameterschätzer
- 14: Rücksetzkanal Parameterschätzer
- 15: Datenaustauschfilter
- 16: Rücksetzkanalfilter
- 17: Prädiktor
- 18: Präditktorparametrierung
- 19: Simulation
- 19.1: Bremsroutine
- 19.2: Lenkroutine
- 19.3: Startroutine
- 20: Stimulanz

## Patentansprüche

1. Verfahren zur Erkennung des Zustandes eines Energiespeichers (1), dessen Istgrößen (2, 3, 4) einem modellbasierten Parameterschätzer (5) zuführbar sind und erhaltene Parametrierungsgrößen (8, 11) einen das Verhalten des Energiespeichers (1) extrapolierenden Prädiktor (17) beaufschlagen, **dadurch gekennzeichnet, dass** die Istgrößen (2, 3, 4) entkoppelt, sowohl dem modellbasierten Parameterschätzer (5), als auch einem Filter (7) zuführbar sind, wobei der modellbasierte Parameterschätzer (5) und das Filter (7) einer Überwachungsebenen (12) untergeordnet sind und erhaltene Parametrierungsgößen (8, 11) den das Verhalten des Energiespeichers (1) extrapolierenden Prädiktor (17) beaufschlagen.

2. Verfahren gemäß Anspruch 1, **dadurch gekennzeichnet, daß** durch Änderungen der Istgrößen (2, 3, 4) des Energiespeichers (1) Anpassungen adaptiver Modellparameter (6) des Parameterschätzers (5) kontinuierlich erfolgen.

3. Verfahren gemäß Anspruch 1, **dadurch gekennzeichnet, daß** die Istgrößen (2, 3, 4) dem Parameterschätzer (5) als Eingangsgrößen (9, 10) in längeren zeitlichen Intervallen t₁ zuführbar sind.

4. Verfahren gemäß Anspruch 3, **dadurch gekennzeichnet, daß** die Istgrößen (2, 3, 4) dem Filter in kürzeren zeitlichen Intervallen t₂ zuführbar sind, mit t₂ < t₁.

5. Verfahren gemäß Anspruch 1, **dadurch gekennzeichnet, daß** die durch Parameterschätzer (5) und Filter (7) geschätzten Parametrierungsgrößen (8, 11) in einer Überwachungsebene (12) auf Plausibilität untersucht werden.

6. Verfahren gemäß Anspruch 5, **dadurch gekennzeichnet, daß** die Überwachungsebene (12) ein Rücksetzen (14, 16) der geschätzten Parametrierungsgrößen (8, 11) und deren Neuschätzung initialisiert oder ein Rücksetzen der geschätzten Parametrierungsgrößen auf zuletzt ermittelte plausible Schätzwerte herbeiführt.

7. Verfahren gemäß Anspruch 1, **dadurch gekennzeichnet, daß** die Plausibilitätsuntersuchung der geschätzten Parametrierungsgrößen (8, 11) anhand eines vorgebbaren Wertebereiches erfolgt.

8. Verfahren gemäß Anspruch 1, **dadurch gekennzeichnet, daß** der Parameterschätzer (5) durch die Überwachungsebene (12) jederzeit aktivierbar ist.

9. Verfahren gemäß Anspruch 1, **dadurch gekennzeichnet, daß** der Prädiktor (17) anhand geschätzter Parametrierungsgrößen (8, 11) von Parameterschätzer (5) und Filter (7) aus einem Belastungsspektrum mögliche Belastungen simuliert.

10. Verfahren gemäß Anspruch 1, **dadurch gekennzeichnet, daß** mittels anwendungspezifischer Stimuli (20) am Prädiktor (17) sicherheitskritische Simulationsroutinen (19.1, 19.2, 19.3) zur Vorhersage des Verhaltens des Energiespeichers (1) durchlaufen werden.

11. Verfahren gemäß Anspruch 1, **dadurch gekennzeichnet, daß** Eingangsgrößen (9, 10) des modellbasierten Parameterschätzers (5) am modellbasiertem Filter (7) Änderungen der Modellparameter (5) des Parameterschätzers (5) durch Parameterübertragung (8) nach sich ziehen.

## Claims

1. Method for identification of the state of an energy store (1) whose actual variables (2, 3, 4) can be supplied to a model-based parameter estimator (5) and whose configuration variables (8, 11) which are obtained are applied to a predictor (17) which extrapolates the behaviour of the energy store (1), **characterized in that** the actual variables (2, 3, 4) can be supplied in a decoupled form both to the model-based parameter estimator (5) and to a filter (7), with the model-based parameter estimator (5) and the filter (7) being subordinate to a monitoring level (12), and the configuration variables (8, 11) which are obtained being applied to the predictor (17) which extrapolates the behaviour of the energy store (1).

2. Method according to Claim 1, **characterized in that** adaptive model parameters (6) for the parameter estimator (5) are continuously adapted by changes to the actual variables (2, 3, 4) for the energy store (1).

3. Method according to Claim 1, **characterized in that** the actual variables (2, 3, 4) can be supplied to the parameter estimator (5) as input variables (9, 10) at relatively long time intervals t₁.

4. Method according to Claim 3, **characterized in that** the actual variables (2, 3, 4) can be supplied to the filter at relative short time intervals t₂, where t₂ < t₁.

5. Method according to Claim 1, **characterized in that** the configuration variables (8, 11) which are estimated by the parameter estimator (5) and the filter (7) are investigated for plausibility in a monitoring level (12).

6. Method according to Claim 5, **characterized in that** the monitoring level (12) initializes resetting (14, 16) of the estimated configuration variables (8, 11) and their reestimation, or causes the estimated configuration variables to be reset to the most recently determined plausible estimated values.

7. Method according to Claim 1, **characterized in that** the plausibility investigation of the estimated configuration variables (8, 11) is carried out on the basis of a value range which can be predetermined.

8. Method according to Claim 1, **characterized in that** the parameter estimator (5) can be activated at any time by the monitoring level (12).

9. Method according to Claim 1, **characterized in that** the predictor (17) simulates possible loads from a load spectrum on the basis of estimated configuration variables (8, 11) from the parameter estimator (5) and filter (7).

10. Method according to Claim 1, **characterized in that** safety-critical simulation routines (19.1, 19.2, 19.3) are run on the predictor (17) by means of application-specific stimuli (20) in order to predict the behaviour of the energy store (1).

11. Method according to Claim 1, **characterized in that** input variables (9, 10) to the model-based parameter estimator (5) result, at the model-based filter (7), in changes in the model parameters (5) for the parameter estimator (5) by parameter transmission (8).

## Revendications

1. Procédé en vue de la reconnaissance d'état d'un accumulateur d'énergie (1) dont les grandeurs réelles (2, 3, 4) peuvent être amenées à un évaluateur de paramètres (5) fondé sur un modèle, et les grandeurs de paramétrisation (8, 11) obtenues alimentent un prédicteur (17) extrapolant le comportement de l'accumulateur d'énergie (1),
**caractérisé en ce que**
les grandeurs réelles (2, 3, 4), découplées, peuvent être amenées à la fois à l'évaluateur de paramètres (5) fondé sur un modèle et à un filtre (7), l'évaluateur de paramètres (5) fondé sur un modèle et le filtre (7) étant subordonnés à un plan de surveillance (12) et les grandeurs de paramétrisation (8, 11) obtenues venant alimenter le prédicteur (17) extrapolant le comportement de l'accumulateur d'énergie (1).

2. Procédé selon la revendication 1,
**caractérisé en ce que**
par des variations des grandeurs réelles (2, 3,4) de l'accumulateur d'énergie (1), des ajustements de paramètres de modèle (6) adaptatifs de l'évaluateur de paramètres (5) s'effectuent de manière continue.

3. Procédé selon la revendication 1,
**caractérisé en ce que**
les grandeurs réelles (2, 3, 4) peuvent être amenées à l'évaluateur de paramètres (5) en tant que grandeurs d'entrée (9,10) à des intervalles de temps t₁ relativement longs.

4. Procédé selon la revendication 3,
**caractérisé en ce que**
les grandeurs réelles (2, 3, 4) peuvent être amenées au filtre (7) à des intervalles de temps t₂ relativement brefs, tels que t₂ < t₁.

5. Procédé selon la revendication 1,
**caractérisé en ce que**
les grandeurs de paramétrisation (8, 11) évaluées par l'évaluateur de paramètres (5) et le filtre (7) sont analysées, du point de vue de leur plausibilité, dans un plan de surveillance (12).

6. Procédé selon la revendication 5,
**caractérisé en ce que**
le plan de surveillance (12) initialise une remise en arrière (14, 16) des grandeurs de paramétrisation (8, 11) évaluées et de leur réévaluation, ou bien entraîne une remise en arrière des grandeurs de paramétrisation évaluées vers des valeurs d'évaluation plausibles déterminées en dernier lieu.

7. Procédé selon la revendication 1,
**caractérisé en ce que**
l'analyse de plausibilité des grandeurs de paramétrisation (8, 11) évaluées s'effectue à l'aide d'une gamme de valeurs prédéfinie.

8. Procédé selon la revendication 1,
**caractérisé en ce que**
l'évaluateur de paramètres (5) peut être à tout moment activé par le plan de surveillance (12).

9. Procédé selon la revendication 1,
**caractérisé en ce que**
le prédicteur (17) simule, à l'aide de grandeurs de paramétrisation (8, 11) évaluées par l'évaluateur de paramètres (5) et le filtre (7), les charges possibles provenant d'un spectre de charges.

10. Procédé selon la revendication 1,
**caractérisé en ce que**
au moyen de stimulations (20) spécifiques aux applications, exercées sur le prédicteur (17), des routines de simulation (19.1, 19.2, 19.3) critiques du point de vue de la sécurité sont parcourues en vue de prédire le comportement de l'accumulateur d'énergie (1).

11. Procédé selon la revendication 1,
**caractérisé en ce que**
des grandeurs d'entrée (9, 10) de l'évaluateur de paramètres (5) fondé sur un modèle entraînent sur le filtre (7) fondé sur un modèle, par transfert de paramètres (8), des variations des paramètres de modèle (6) de l'évaluateur de paramètres (5).
